# EUROPEAN PATENT SPECIFICATION

(11) **EP 0 913 448 B1**
(45) Date of publication and mention of the grant of the patent: **18.06.2003**
(21) Application number: 98122846.3
(22) Date of filing: 25.05.1995
(51) Int. Cl.: C09K 11/06, C09K 11/04, C07F 9/535, C07F 9/53

(54) **Fluorescent compound**
Fluoreszierende Verbindung
Composé fluorescent

(43) Date of publication of application: 06.05.1999
(62) Divisional of application: 95303551.6
(73) Proprietor: AEA Technology plc, Didcot, Oxfordshire OX11 0QJ (GB)
(72) Inventor: Bell, Colin David, Radyr, Cardiff CF4 8DJ (GB); Bosworth, Nigel, Danescourt, Cardiff CF5 2RQ (GB); Howse, John Hewer Coles, Cycoed, Cardiff CF2 6SQ (GB); James, Martin David, Three Crosses, Gower, West Glamorgan (GB)
(74) Representative: Wilkinson, Stephen John

(56) References cited:
- EP-A- 0 556 005
- DATABASE WPI Section Ch, Week 8947 Derwent Publications Ltd., London, GB; Class E19, AN 89-344262 XP002091423 & JP 01 256 584 A ( IDEMITSU KOSAN KK) , 13 October 1989
- DATABASE WPI Section Ch, Week 8652 Derwent Publications Ltd., London, GB; Class E36, AN 86-343406 XP002091424 & JP 61 258 026 A (KOBE STEEL LTD) , 15 November 1986

## Description

This invention concerns polymer bodies which are light-emitting by virtue of containing a transition or lanthanide or actinide metal chelate or other complex. For the most part, the energy for light emission is provided by internal radioactivity, e.g. by using a tritiated polymer. In the course of the work leading to this invention, novel compounds based on certain metal chelates have been identified as having outstanding fluorescent properties. These compounds, and polymer bodies containing them, also form part of this invention. All these compounds and chelates are fluorescent, in the sense that they emit light or other relatively long wavelength electromagnetic radiation, on being subjected to UV or other relatively short wavelength electromagnetic radiation, including ionising radiation from radioactive decay. It is surprising that the compounds and chelates show high efficiency of light output and good stability in the presence of ionising radiation.

EP-0556005 A1 describes a solid body comprising a polymer together with a chelate of a transition or lanthanide or actinide metal, the body having the property of emitting light when subjected to a flux of electromagnetic radiation. Preferably the polymer is radioactively labelled with tritium so that the radioactive decay provides the ionising radiation.

EP-0556005 A1 also describes compounds that result from reacting together an imido-reactant of the formula O=QRR-N-Z, where Q is P, As or Sb; R is aromatic or heterocyclic; and Z is QR₃ or an organophosphoranyl group, with a chelate of a transition or lanthanide or actinide metal, which compounds have the property of fluorescing in UV radiation. A preferred compound is tris (2,2,6,6-tetramethyl-3,5-heptanedionato) terbium III diphenyl-phosphonimido-triphenyl phosphorane (ALP-1).

For the present invention, the inventors have built on the work described in EP-0556005-A1. The present specification describes:
- New compounds ALP-3 and ALP-7 which have advantages over ALP-1,
- New formulations containing siloxanes and free-radical scavengers used with these new compounds and with known transition or lanthanide or actinide metal chelates to give fluorescent bodies having superior properties.

The present invention is defined by the claims set out below.

The metal chelate may be the same as or similar to the known classes of metal chelate referred to above. However, it needs to have a number of special properties not always possessed by the known fluorescers:
- It needs to be capable of fluorescing under the impact of UV or other electromagnetic radiation, not only in pure form but also in dispersion or solution in an organic monomer or polymer.
- It is preferably soluble in the monomer or monomer mix used to form the polymer body. A solubility of at least 10% by weight is generally preferred. The metal chelate should preferably remain soluble as the monomer polymerises.
- The presence of the metal chelate should preferably not inhibit polymerisation of the monomer to a transparent wholly or substantially colourless polymer.

In principle, any metal ion having an unfilled inner electron shell, that is to say almost any transition or lanthanide or actinide metal ion, can be used as the basis of the fluorescent chelate. In practice, a metal ion having a convenient emission frequency, and a convenient resonant frequency, and an efficient transition between the two, is most usually chosen. The most usual are the lanthanide metal ions Sm 3+, Eu 3+, Tb 3+, Dy 3+, Yb 3+, Lu 3+, Gd 3+, Eu 2+, and the actinide metal ions U 3+ and UO₂ 3+. Transition metal ions are useful for fluorescing in the visible and also in the infra-red range.

The chelating or complexing groups are chosen to have a triplet energy level similar to but slightly higher than the resonant energy level of the chosen metal ion. Known chelates, including those described in the abovementioned references are likely to be suitable, including those based on diketone and triketone chelating moieties. A preferred chelating group has the formula 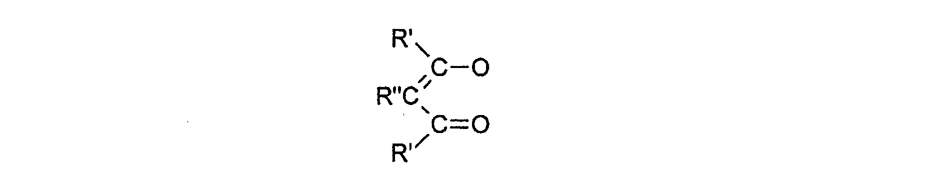 where R' may be the same or different at different parts of the molecule and each R'' and R' is an aromatic or heterocyclic ring structure which may be substituted or hydrocarbon or fluorocarbon or R'' is hydrogen. The identity of R'' can be used to modify the triplet energy and may affect light emission. R'' can also be made co-polymerisable with a monomer, e.g. styrene.

In the compound described in Example a) below, R' is t-butyl and R'' is hydrogen. Metal chelates may have up to four, typically three, of such groups surrounding the metal ion.

Examples of metal chelates useful in this invention are:-
a) Terbium (3+) (dipivaloylmethide)₃, otherwise known as terbium tris(2,2,6,6-tetramethyl-3,5-heptanedionato) chelate, commercially available from Strem Chemicals.
b) The di- and tri-pyrazolyl borate and the di-and tri-pyrazolyl-N-oxide borate adducts of a).
c) Europium (3+) (2-naphthyl trifluoroacetyl acetonate)₄
d) Uranyl (2-naphthyl trifluoroacetyl acetonate)₄. This material emits strongly in the yellow part of the spectrum when cooled to about -50°C.
e) The dipyridyl and dipyridyl-N-oxide adducts of c) and d).

It is preferred to use a compound that results from reacting together a phosphine oxide or an imido-reactant of formula 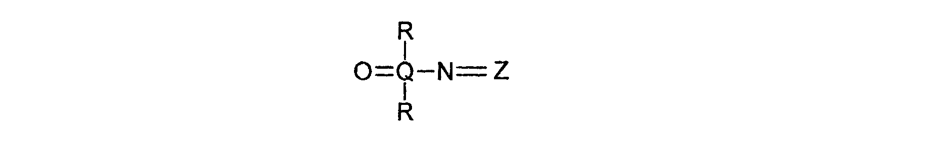 where Q may the same or different at different parts of the molecule and is P, As or Sb,
and R may be the same or different at different parts of the molecule and each R is an aromatic or heterocyclic ring structure which may be substituted or unsubstituted, provided that one group R may alternatively be a co-polymerisable group,
and Z is either QR₃ or an oligophosphoranyl group (an organophosphoranyl group with two or more P atoms),
with a chelate of a transition or lanthanide or actinide metal ion to produce a product which has the property of fluorescing in UV radiation.

These compounds are expected to have the formula

(Xₙ - M - O - QR₂ - N)ₚ Z or Xₙ - M(-O-QR₂-N=Z)ₛ

where M is the transition or lanthanide or actinide metal ion, such as those described above,
X is a chelating group,
n is 1 to 4,
p is 1 to 4, and
s is 1 to 4 preferably 1 or 2.

In the above structures, Q may be Sb or As or P, the latter being preferred. At least four of the five groups R should be of aromatic or heterocyclic character, the following being examples: phenyl; p-tolyl; 2,4-dimethylphenyl; p-tertiary butyl phenyl; 1-naphthyl; 2-naphthyl; 4-pyridyl; 4-quinolyl.

Z may be an oligophosphoranyl group, e.g. of the formula:

Ar₁ - P - [(Alk-P-Ar)ₘ - Alk - P - Ar₂]_{q}

where Ar is aryl preferably phenyl,
Alk is alkene preferably -C₂H₄-,
l, m and q are small integers such that l+q is 3,
these compounds being of the kind commercially available as:-
Diphos - Ph₂PC₂H₄PPh₂.
Triphos - Ph₂PC₂H₄P(Ph)C₂H₄PPh₂.
Tetraphos I - Ph₂PC₂H₄P(Ph)C₂H₄PPhC₂H₄PPh₂.
Tetraphos II - P(C₂H₄PPh₂)₃.
(See JACS 93:17 August 25 1971; 4158-4166). For example, a compound according to the invention based on Diphos would have the formula:

Xₙ-M-O-P(Ph)₂-N-P(Ph)₂-C₂H₄-P(Ph)₂-N-P(Ph)₂-O-M-Xₙ

where Ph is phenyl.

Alternatively, one of the groups R may be a co-polymerisable group, that is to say a group capable of joining in a polymerisation reaction with a monomer with which the compound is mixed. Examples are carboxylic and sulphonic acid groups, and ethylenically unsaturated hydrocarbon groups such as allyl and p-styryl. A preferred imido reagent has the formula 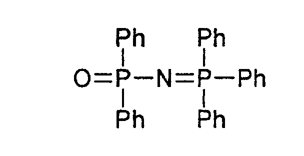 where Ph is phenyl.

Other compounds envisaged are those which result from reacting together a phosphine oxide of formula 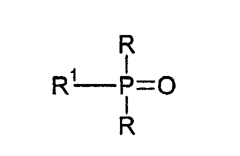 where R is aromatic or heterocyclic and R¹ is R or 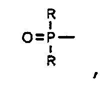 with a chelate of a transition or lanthanide or actinide metal ion. The three groups R of the phosphine oxide may be the same or different. Preferably they are different, as this has been found to increase the solubility of the compound in organic monomer/polymer systems. Thus in a preferred compound, two of the groups R are phenyl and the third is p-tolyl. This can be compared for example to the phosphine oxide in which all three groups R are phenyl. When compounds are made by reacting these phosphine oxides with chelates of transition or lanthanide or actinide metal ions, the compound derived from p-tolyl diphenyl phosphine oxide is more lipophilic and has an even higher solubility in a styrene/polystyrene system than does the compound derived from triphenyl phosphine oxide.

A particularly preferred compound is that which results from reacting p-tolyl diphenyl phosphine oxide with trivalent terbium tris(dipivaloyl methide). This compound is expected to have the formula

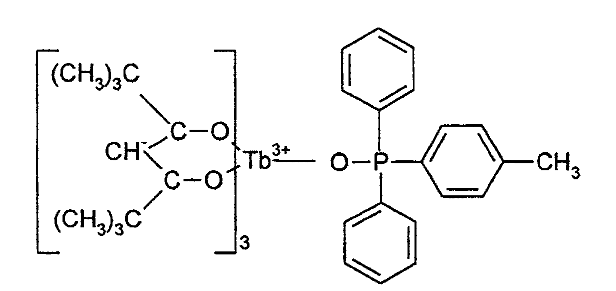

This compound is hereinafter called ALP-3, and has the following characteristics:-
a) It is almost as efficient as ALP-1 per molecule of phosphor.
b) It is of comparable solubility in a polymer matrix;
c) It is more radiation stable than ALP-1 in the formulations shown in the examples below.

Another preferred compound is that which results from reacting a compound that results from reacting diphenyl-phosphonimido-triphenyl phosphorane with tris [4,4,4-trifluoro-1-(2-naphthyl)-1,3-butanedionato]europium (3+). This compound is expected to have the formula

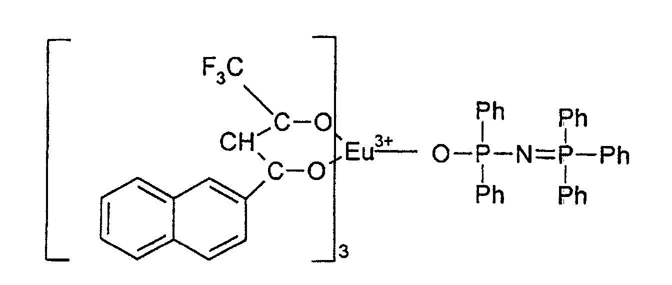

Alternatively the phosphine oxide may be a dimer 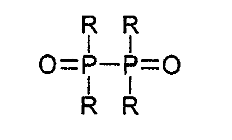 which can be reacted with chelates of two transition or lanthanide or actinide metals M¹ and M² to give compounds of the structure

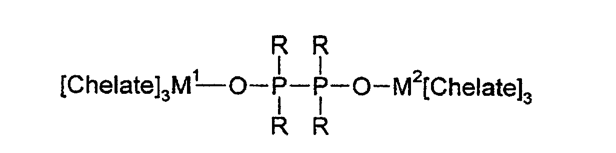

For example the chelating group may be a highly planar structure such as naphthyl trifluoroacetyl, and the two metal ions may be the same e.g. Eu³⁺ or different e.g. Eu³⁺ and Gd³⁺ (for energy transmission by ion to ion transfer).

Preparation of the compounds of this invention is straightforward. Rare earth chelates having the property of fluorescing in UV radiation are well known. A. P. B. Sinha (Spectroscopy in Inorganic Chemistry edited by C. N. R. Rao and John R. Ferraro, Vol. 2, Academic Press 1971 - History of Congress Catalogue No. 77-117102) describes several classes of rare earth chelates with various monodentate and bidentate ligands. Some are commercially available. General methods of preparation are described by Reid and Kelvin (Journal of the American Chemical Society, 72 (1950), 2948-2952). Imido reagents are known materials (see the Kallistratos reference above) whose preparation is described by R. A. Baldwin and R. M. Washburn (Journal of the American Chemical Society, 83, pages 4466-4467, 1961) and M. J. P. Harger and S. Westlake (Tetrahedron, 38, No. 10, pages 1511-1515, 1982). Phosphine oxides are also known materials. To prepare compounds according to the present invention, the chosen metal chelate and the chosen phosphine oxide or imido-reactant may be heated together in molar quantities defined by the formulae above at a melting temperature of 200°C for one hour. More preferably, appropriate molar quantities of the two reactants are heated together in a refluxing organic solvent. The inventors have found trimethylpentane when s is 1 and toluene when s is 2 to be convenient. If the starting metal chelate is insoluble, progress of the reaction can be monitored by noting that the refluxing solution clears. On cooling, the desired product crystallises out in easily recoverable form.

This aspect of the invention is not restricted to compounds prepared by this route, and other preparative methods are possible. For example, one molar part of a complex of the metal ion with the phosphine oxide or imido-reactant may be heated with generally 2-4 molar parts of the chelating moiety so as to form the desired compound.

The compounds, individually, have the property of fluorescing, in the visible or infra-red region depending on the metal ion chosen, when subjected to UV or other energetic radiation. This property may be exploited in various ways. For example, the compound may be applied as a coating on a glass vessel or on glass beads, and these may be maintained in the presence of a radioactive gas such as tritium or xenon-133 or krypton-85.

The compounds, in combination, may act in a less well known manner. In certain circumstances the energy collected by the metal ion of one structure will not be emitted by that ion but will be transferred most efficiently, by so-called radiationless transfer, to a second different metal ion (chelated). This phenomenon, known as 'ion to ion transfer' can be made very efficient by careful selection of the two metal ion structures. For example, trivalent gadolinium structures do not usually emit light even in isolation but, in combination with known fluorescent lanthanide chelates, they prove to be very efficient energy collectors. Such metal ion chelate pairs can be of greater efficiency than any one chelate on its own.

The compounds of this invention are particularly useful in polymer compositions. Thus in another aspect the invention provides a body comprising a polymer together with at least one compound as described above, the body being capable of emitting light or infra-red radiation when subjected to a flux of ultra violet or ionising electromagnetic radiation. The body is preferably solid, but may alternatively be liquid, in which case it is contained in a transparent or translucent glass or plastic vessel. Preferably, the flux of electromagnetic radiation is generated internally by radioactivity in the body.

Thus, either the polymer or the metal chelate (which term is hereafter used to include novel compounds of this invention) or a siloxane component may be radio-labelled, preferably with tritium. In these compositions, the metal chelates act as scintillants, either alone or in conjunction with conventional organic scintillants.

Polymers labelled with tritium are well known, and are most conveniently prepared by labelling a monomer or co-monomer with tritium prior to polymerisation. The polymer should preferably be clear for maximum efficiency at the wavelength of the emitted light, and should preferably be resistant to damage by self-irradiation (E.A. Evans, Tritium and Its Compounds, 2nd Edition, Butterworths, London 1974 pages 720-721). On these grounds, polymers of vinyl-aromatic hydrocarbons, such as styrene and vinyltoluene, are preferred. A Gₛ (scission) value of 0.04 is quoted for irradiation of polymethylstyrene and a Gₓ (cross-linking) value of 0.02 which is much less than for other known polymers, see Polymer Photophysics and Photochemistry by J. Guillet Pub. Cambridge University Press, 1985 page 353 et seq. Some or all of the protium hydrogen in the polymer and/or in the metal chelate may be replaced by deuterium. Additional stability is however conferred on the composition by the presence of the metal chelates, by virtue of their conversion of beta radiation energy into light, reducing the proportion of energy available for self-irradiation of the polymer.

The extent of tritium labelling is a compromise between several factors. By incorporating 2 atoms of tritium per monomer molecule, it is possible to achieve activities of 600 Ci/g. Such monomers may be diluted with non-radioactive monomer, or the monomer prepared using tritium-hydrogen mixtures in the tritiation/hydrogenation step, to achieve the overall specific radioactivity required. Activities below about 100 mCi/g are rather unlikely to be useful as illuminating devices but do have a use as light sources for calibration. As the tritium labelled polymer is a relatively expensive material, it will generally be preferred to use the minimum required to achieve the desired light output. All polymers labelled with radioisotopes including polystyrene suffer from radiation damage, and at high levels of activity this may lead to darkening with loss of light output, and eventually to embrittlement and degradation. Labelling to an activity of from 25nanocuries/gram to 100 Ci/g, particularly 50nanocuries/gram to 5curies/gram, of composition may be appropriate in many cases, with activities towards the lower end of that range where a service life of more than five years is required.

Tritiated vinyl aromatic monomers may be made by the catalytic partial reduction by tritium of substituted acetylenes. For the purpose of this invention, reduction is carried out with tritium-hydrogen or tritium-deuterium mixtures up to 100 per cent isotopic abundance of tritium as required, preferably in the presence of a platinum or palladium catalyst or other suitable hydrogenation catalyst. The catalyst chosen should not contain volatile components such as quinoline and should not be adversely affected by monomer stabilisers. After the reduction it is preferable to remove by filtration or by distillation any catalyst from the tritiated monomer. It is also preferable to dilute the tritiated monomer with non-radioactive monomer(s) which have been purified either by distillation or by passage through a column of neutral alumina. Vinyl aromatic monomers which are tritium labelled on the aromatic ring are also known and may be used.

It is preferred to include a siloxane in the bodies of this invention. Siloxanes can have two beneficial effects. First, they may increase the initial light output. Second, they may slow down the inevitable drop in light output that occurs when the solid body is radioactively labelled with tritium, thus increasing the light output obtainable over a prolonged period of time. Preferred siloxanes may show both these effects. Preferred siloxanes comprise the grouping 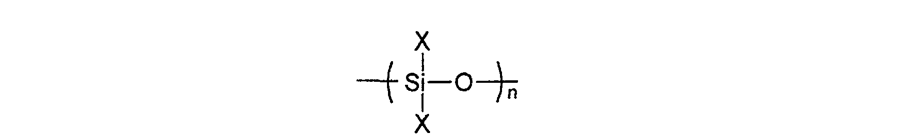 where X is aromatic or heterocyclic or C1-C4 alkyl or alkenyl and n is an integer of at least 1. Examples of useful siloxanes are tetraphenyltetramethyltrisiloxane (sold as Dow 704) and pentaphenyltrimethyltrisiloxane (sold as Dow 705). The siloxane may preferably be present in a proportion of 5- 100%, particularly 10 - 40%, by weight on the weight of the solid body.

The body contains a free radical scavenger which reduces polymer degradation. A preferred free radical scavenger is tetralin. A preferred concentration is 1 - 5% by weight.

When a component of the body of this invention is radioactively labelled with tritium, this component may be a polymerisable siloxane. Thus, divinyltetraphenyldisiloxane may be partly reduced with tritium gas to yield a tritium-labelled siloxane moiety.

A polysiloxane may be used in partial or even total replacement of a poly-(vinyl aromatic compound). When some groups X are alkenyl, cross-linking of the polysiloxane to give a solid product is possible.

The concentration of the metal chelate should be enough to efficiently convert the beta-radiation into visible light, but not so great as to inhibit polymerisation of the monomer mix or to substantially harm the properties of the polymer. While optimum concentrations may vary depending on the nature of the polymer, the extent of tritium labelling, and the nature of the scintillant, suitable concentrations are likely to lie in the range 1 µg to 500 mg, preferably 50 - 400 mg of total scintillant per ml of polymer. The concentration of scintillants are optimised for the light output required but too high a concentration will result in self-absorption of the light and thus reduce the efficiency - see Design Principles of Fluoresence Radiation Converters by G. Keil in Nuclear Instruments and Methods 87, 111-123 (1970).

A cross-linking agent may be included in the monomer mix and may be beneficial in increasing light output, and in stabilising the composition against radiolytic decomposition, as discussed below. For example, with a vinyl aromatic system, up to 50 g/l of divinylbenzene may be useful.

These light-emitting polymer compositions may be made by providing a reaction mix comprising at least one polymerisable organic monomer, preferably a vinyl-aromatic hydrocarbon, labelled with tritium, and at least one metal chelate scintillant,and subjecting the reaction mix to polymerisation conditions. The scintillant is preferably present in solution in the monomer. Transition metal chelates are often sparingly soluble in vinylaromatic monomers; a preferred feature of adducts such as the aromatic imido-moiety is to render the compounds of this invention highly soluble. Preferably, polymerisation of the monomer or monomers is effected by heat in the presence or absence of free-radical polymerisation initiators and in the substantial absence of oxygen. When the polymerisation reaction is exothermic, careful temperature control of the reaction mix may be needed to avoid thermal decomposition of the organic scintillators. The reaction mix may be shaped prior to polymerisation to generate plastic sheets of desired thickness, rods, filaments, microbeads, capillary tubing, or other desired shapes. After polymerisation, the solid products can also be cut and shaped as desired. These shapes may be "silvered" or combined with or contained within other reflective materials in known manner to increase directional light output. Thus the body may be in the shape of cylinder with the curved surface made internally reflecting, or of a chord of a cylinder with the curved surface and the ends made internally reflecting.

Upon polymerisation of the monomer mix, the light emitted by the composition increases, to an extent that is dependent on various factors: use of purer reagents; increasing molecular weight of the polymer (and for this reason a cross-linking agent may be beneficial); cooling the product; stretching the product or otherwise inducing molecular ordering; all these steps may increase light output from a given composition.

The light emitting compositions of this invention are useful wherever a continuous or intermittent independent light source is required and power lines or batteries cannot conveniently be provided, or in inactive form as a detector of radiation, or where extremes of temperature preclude use of chemical batteries. Some examples are:
- Production of electricity by combination with photocells.
- In liquid scintillation compositions as well as polymers, e.g. for liquid scintillation beta measurements.
- In radiation, e.g. X-ray, visualisation screens where the efficiency of the new phosphors may be used to reduce exposure and/or improve definition.
- Light sources for signs, gun-sights, markers on instruments.
- Large light sources on airfields and other situations where remote lighting may be required (see also G. Foldiak in Industrial Application of Radioisotopes, Pub. Elsevier 1986, p.386 et seq. and A Novel Light-Collection System for Segmented Scintillation-Counter Calorimeters, V. Eckardt, R. Kalbach, A. Manz, K. P. Pretzl, N. Schmitz and D. Vranic, Nuclear Instruments and Methods,155, 389-398 (1978).

Reference is directed to the accompanying drawings in which:
- Figures 1 to 4 are graphs of light output against time for various formulations.
- Figures 5 and 6 are graphs of initial light output and rate of diminution of light output against the concentration of a formulation component.
- Figure 7 is a graph of decomposition rate against radioactive concentration.

As demonstrated in Examples 2 and 3 below, preferred light emitting polymer formulations according to the present invention show the following stability:-
a) At 1 Curie per gram or 1 Curie per cc a light output degradation rate below 1% per month, e.g. matching the decay rate of tritium itself i.e. 0.467% per month or 5.46% per annum.
b) At 2 Curies per gram or 2 Curies per cc, a light output degradation rate of below 2% per month, e.g. about 1% per month.

The following examples illustrate the invention. Example 1 is reproduced from EP-0556005-A2. Examples 2 and 4 describe the preparation of ALP-3 and ALP-7 respectively. Examples 3 and 5 describe the preparation and properties of formulations containing these compounds.

### EXAMPLE 1

### Tris(2,2,6,6-tetramethyl-3,5-heptanedionato)terbium III-diphenyl-phosphonimidotriphenyl phosphorane (ALP-1)

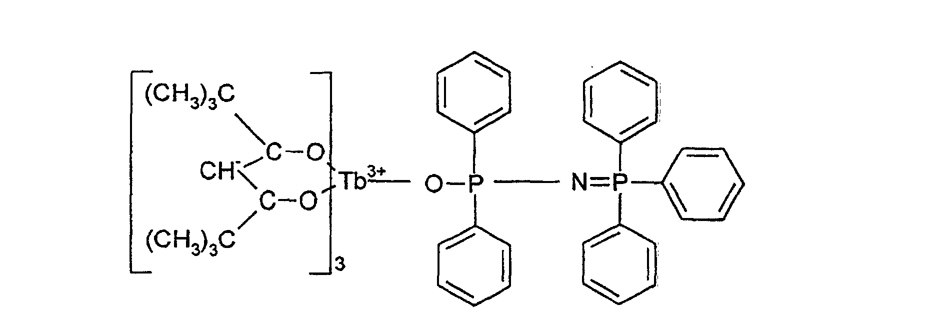

Tris(2,2,6,6-tetramethyl-3,5-heptanedionato)terbium III+ (2) was purchased from Strem Chemicals Inc.

Diphenyl-phosphonimido-triphenyl phosphorane (3) was prepared by a method given in the references quoted above. Diphenyl-phosphinic acid chloride (68 g) and sodium azide (30 g) were stirred in dried acetonitrile (380 ml) for 64 hours. Diphenylphosphinic azide precipitated out of solution, was filtered off and washed with acetonitrile and dried to yield 72.3 g.

24.1 g (100 mM of the diphenylphosphinic azide was dissolved in dry diethyl ether (50 ml) to yield 70 ml solution. Triphenylphosphine (26 g 100 mM) was dissolved in diethyl ether (dried 160 ml) and the two reagents mixed and refluxed in a 500 ml flask fitted with a reflux condenser.

The precipitated material was filtered off, washed with a) ether, b) dilute ammonia solution (10 ml of 2N ammonia diluted to 100 ml), and c) water (5 x 100ml), and dried at room temperature under vacuum to yield 36.31g (76% of theory) of (3).

1 mM of (2) was mixed with 1 mM of (3) in a total of 5 ml trimethyl pentane, and the mixture heated to reflux until a clear solution was obtained (about 1 hour). The solution was allowed to cool yielding (ALP-1) as a crystalline solid in nearly quantitative yield.

### EXAMPLE 2

### A. PREPARATION OF PHOSPHOR (ALP-3)

### 1. Preparation of (4-methylphenyl)diphenyl phosphine oxide

(4-methylphenyl)diphenyl phosphine [1031-93-2] (Aldrich 15503-9) was purified by (Kugelrohr) distillation at 200°C/10⁻¹ torr to a white solid. 92% recovery.

Distilled (4-methylphenyl)diphenyl phosphine (23 g) was dissolved in tetrahydrofuran (150 ml) (Rathburn HPLC grade), cooled to 15°C in water bath, hydrogen peroxide 30% w/v aqueous solution 20 ml (BDH) was slowly added over 30 minutes and then stirred for a further 16 hours at 20-25°C. Solution was then rotary evaporated to remove solvents and residue redissolved in toluene 150 ml (Rathburn, glass distilled). This solution was washed with saturated sodium bicarbonate solution (100 ml), the solution dried over sodium sulphate, filtered and rotary evaporated to dryness. The residue was purified by Kugelrohr distillation at 250°C/0.1 torr. The distillate was transferred into a separate flask with tetrahydrofuran, rotary evaporated to dryness and the solid residue washed with pentane (3x30 ml) and the solid dried by rotary evaporation and pumping under vacuum 10⁻¹ torr at room temperature. Yield: 21.0 grams.

### 2. Preparation of (4-methylphenyl)diphenyl phosphine oxide derivative of trivalent terbium tris(dipivaloyl methide) (Th³⁺(DPM)₃)

(4-methylphenyl)diphenylphosphine oxide - mol. wt. 292.317 (30.0 grams, 0.103 moles) and trivalent terbium (tris(dipivaloyl methide) [15492-51-0], Tb³⁺(DPM)₃ (Terbium 2,2,6,6-tetramethyl-3,5-heptanedionate) (73grams, 0.103 moles Fluorochem Tb-000800) were refluxed in trimethylpentane (200 ml, Rathburn HPLC grade) for 25 minutes to give a cloudy solution. The reaction mixture was allowed to cool to room temperature and stood for 3 hours. The product was filtered off, washed with pentane (30 ml, Rathburn HPLC grade) and dried at room temperature under vacuum 10⁻² torr for 1½ hours.

The product was dissolved in diethyl ether (Rathburn) 500 ml, filtered through a 1.5 micron glass fibre mat filter and rotary evaporated to dryness. The product was recrystallised from trimethyl pentane three times and finally pumped to dryness under vacuum at 10⁻¹ torr for 24 hours.

Yield 57 grams plus 35 grams recovered from mother liquors.

Quality test:- A 30% w/v solution in styrene should be totally transparent, haze-free and water white in appearance and should polymerise to a transparent fluorescent water white polymer.

### EXAMPLE 3

### Preparation of Tritium Carrier

### Materials

Triphenylvinylsilane (ABCR Chemicals T3960) (now known to be divinyl tetraphenyl disiloxane)
10% Palladium on charcoal (JM 33161) Benzene (Aldrich 15,630-1).

### Method

Triphenylvinylsilane (475 mg) and 10% palladium on-charcoal (20 mg) were placed in a dry tritiation vessel (55 ml) with benzene (10 ml).

The reaction mixture was tritiated over 20hrs with 100 Ci of tritium gas (98% isotopic purity) using a multi-port tritiation apparatus.

The reaction mixture was filtered, the catalyst washed with toluene (2 x 10 ml) and solvent removed under vacuum.

Labile tritiated products were then removed by dissolving the product in ethanol (10ml) and evaporating under vacuum. This process was repeated twice. The total activity of tritiated product was then determined by liquid scintillation counting of a solution in toluene (30 ml), (yield = 100 Ci). The toluene was then removed under vacuum, residual toluene was removed by addition and evaporation of pentane (20ml) under vacuum.

The product (white solid) was placed in a desiccator (10⁻¹ mbar) for 1 hour and stored at ambient conditions under an argon atmosphere.

### Formulation of Inactive Monomer Solution Materials

ALP-1
Styrene (Fluka 85959)
Alumina (ICN Biomedicals, Neutral, Super)
Dicumyl peroxide (Polysciences, Inc. 01444)
Dow 704 (Eu) (Dow Corning)
Tetralin (Aldrich 10,241-5)
Divinylbenzene (Polysciences 1892) (Note that this material is only 50% divinylbenzene. The other 50% is ethyl styrene).

### Methods

Styrene (200 ml) was passed through a column of alumina (150 g) and degassed by freeze/thawing (x3) with liquid nitrogen under vacuum (10⁻¹ mbar). The material was stored at ambient conditions under an argon atmosphere.

Divinylbenzene (10 ml) was prepared as per styrene.

Tetralin (50 g) was passed through a column of alumina (10 g) and degassed by freeze/thawing (x3) with liquid nitrogen under vacuum (10⁻¹ mbar). The material was stored at ambient conditions under an argon atmosphere.

Dow 704 (Eu) (50 ml) was degassed by freeze/thawing (x3) with liquid nitrogen under vacuum (10⁻¹ mbar). The material was stored at 60°C, 10⁻¹mbar for 18 hours prior to final formulation with ALP-1.

Inactive LEP monomer solution (100 ml). ALP-1 (24.0 g) solid was degassed by placing under vacuum (10⁻¹ mbar) then purging with argon in a graduated vessel. Tetralin (1.0 ml), divinylbenzene (2.0 ml) and styrene was added to make the final volume 80 ml. Residual gases were then removed by freeze/thawing (x3) with liquid nitrogen under vacuum (10⁻¹ mbar). Dow 704 (Eu) (20 ml) and dicumyl peroxide (250mg) were added to give the final inactive monomer formulation which was stored at ambient conditions under an argon atmosphere.

### Formulation and Polymerisation of Active Solution Materials

[³H]-Ethyltriphenylsilane (as described above).

Inactive LEP monomer solution (as described above).

### Method

The inactive monomer solution (100 ml) was added to [³H]-ethyltriphenylsilane tritium carrier (100Ci) under argon. The radioactive concentration was then determined by liquid scintillation counting. 100x 1.0 ml aliquots were dispensed and flame sealed into 2 ml Wheaton cryovacules under argon and polymerised at 80°C for 48 hrs. After 48 hours the samples were allowed to cool to ambient temperature over 6 hours.

| Formulation | |
|---|---|
| ALP-1 | 24% |
| Dow 704 (Eu) | 20% |
| Dicumyl peroxide | 2.5 mg/ml |
| Tetralin | 1.0% |
| Styrene monomer | |
| Divinylbenzene 2% (effectively 1% DVB) | |
| [³H]-Ethyltriphenylsilane | |
| 1.0 Ci/ml | |

The mixture was polymerised as above.

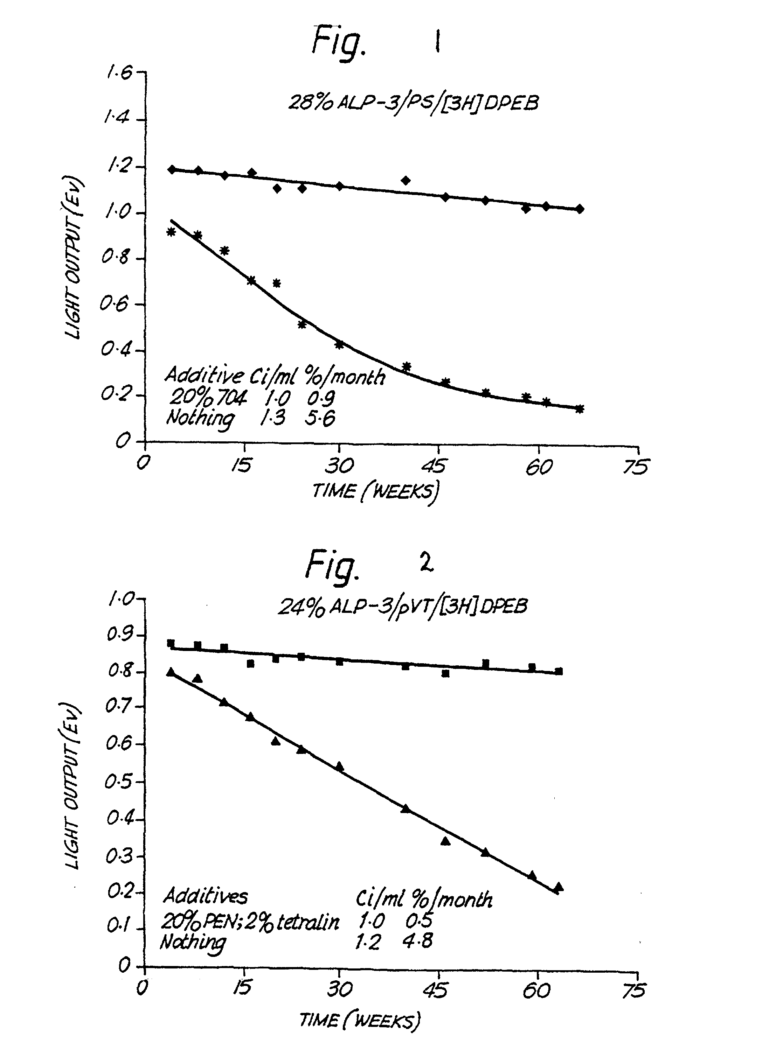

Other related formulations were made by generally similar methods, and tested to obtain the results shown in Figures 1 to 7, in which:-
ALP-1 is the phosphor of Example 1.
ALP-3 is the phosphor of Example 2.
PS is polystyrene.
PVT is polyvinyltoluene.
[³H]DPEB is [³H] diphenylethylbenzene.
704 or Dow 704 is tetraphenyltetramethyltrisiloxane
PEN is pentaphenyltrimethyltrisiloxane.
TET is tetralin.

In each graph, the proportions by weight of scintillant, siloxane, free radical scavenger are stated. The concentration of a tritium-labelled component is expressed in Curies per ml. The balance of the formulation was organic polymer, polystyrene or polyvinyltoluene.
Figure 1 shows that ALP-3 is an effective scintillant, and that light output and stability are improved by incorporating Dow 704 siloxane.
Figure 2 shows that ALP-3 is an effective scintillant in a different formulation; and that PEN and tetralin are together effective in improving light output and stability.

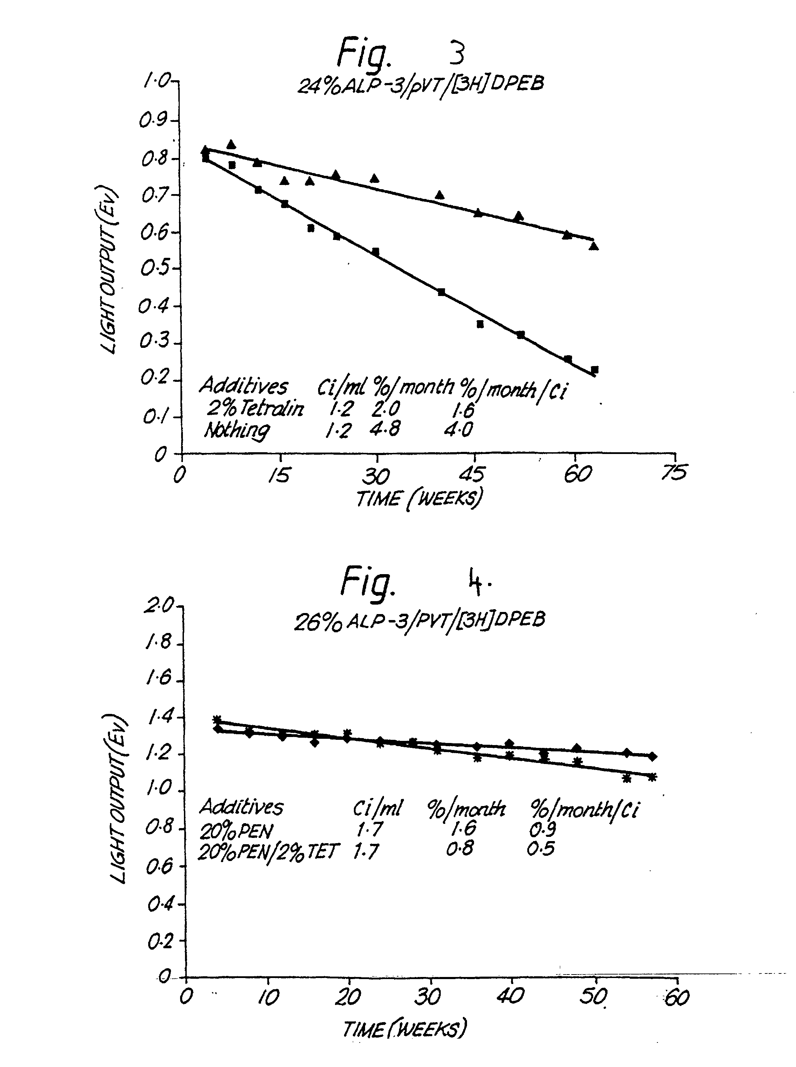

Figure 3 shows the effect of tetralin alone in improving light output and stability.

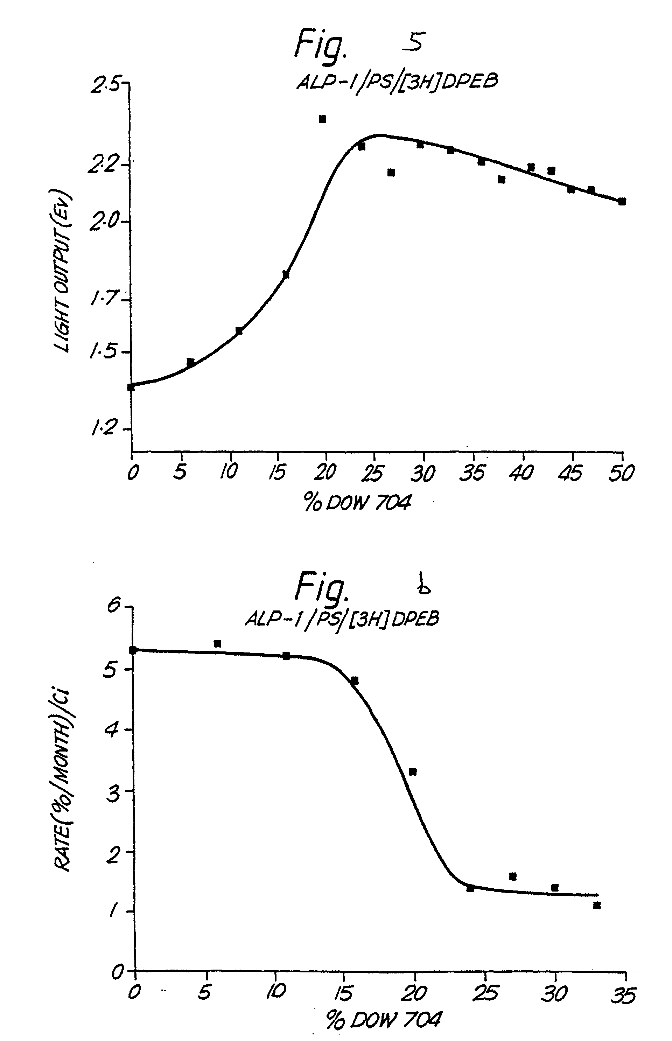

Figure 4 shows formulations with a higher radioactive concentration having excellent light output and stability properties.
Figure 5 is a graph of initial light output against concentration of Dow 704 siloxane, which was added to a 30% ALP-1 solution in styrene.
Figure 6 is a comparable graph of rate of loss of light output against Dow 704 siloxane concentration in the same ALP-1 formulation. Both graphs show an optimum concentration of Dow 704 to be around 20 - 30%.

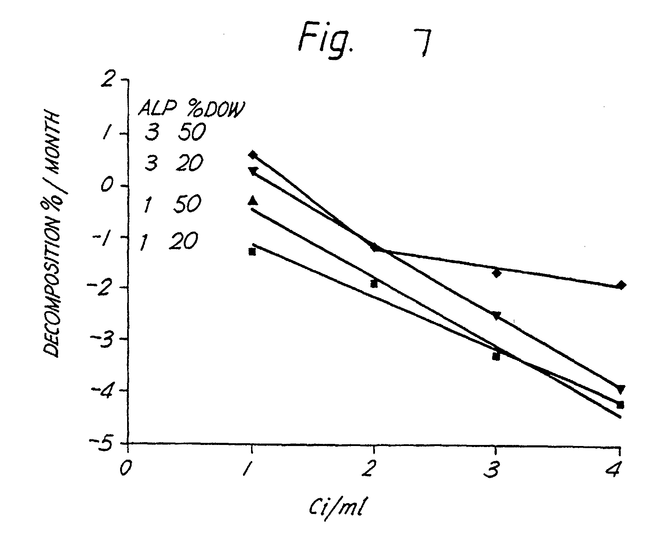

Figure 7 is a graph of decomposition rate against radioactive concentration for various formulations containing 30% ALP-3 in vinyltoluene or 30% ALP-1 in styrene together with either 50% or 20% by weight of Dow 704 siloxane. In these formulations the tritium-labelled component was divinyltetraphenyldisiloxane partly reduced with tritium.

### EXAMPLE 4

### A. PREPARATION OF PHOSPHOR (ALP-7)

### 1. Preparation of tris (4,4,4-trifluoro-1-(2-naphthyl)-1,3-butanedionato)europium (3+)

4,4,4-Trifluoro-1-(2-naphthyl)-1,3-butanedione (NTFA), 99% F.W. 266.62 m.p. 74-76° [893-33-4] (Aldrich 34,363-3), 300 millimoles, 79.87 grams was dissolved in hot methanol 600 millilitres (Rathburn) and a solution of sodium hydroxide 300 millimoles 12 g (BDH) dissolved in a mixture of distilled water, 25 ml, and methanol, 75 ml (Rathburn), was added to the stirred hot (40°C) NTFA solution to form a clear pale yellow solution of the sodio derivative of NTFA.

Europium (III) chloride hexahydrate, F.W. 366.41, 99.9% [13759-92-7] 100 millimoles, 36.64 grams (Aldrich 21,288.1) was dissolved in warm (40°C) methanol, 200 millilitres (Rathburn). This solution was stirred and brought to reflux. To the stirred refluxing solution was added the solution of the sodio derivative of NTFA at a rate of 4 millilitres/minute. After completion of the addition of the sodio derivative, the solution was stirred and refluxed for a further 30 minutes, then allowed to cool and the methanol removed by evaporation at room temperature overnight leaving a solid mixture of Europium (III) (NTFA)₃ dihydrate (F.W. 983.62) and sodium chloride byproduct. The solid was then washed with water (4 x 50 ml) to remove sodium chloride and the resulting crude product dried under vacuum at 40°C.

Yield 130 g.

This crude reaction product was purified by extracting with benzene. 500 ml (Aldrich 15630-2) using a soxlet extractor for 6 hours. The benzene extract was transferred to a litre beaker and allowed to crystallise overnight. The crystalline product was dried at room temperature under vacuum. Yield 54.8 g (55.5% of theoretical yield).

Analysis - identity by X-ray analysis.

### 2. Preparation of tris[4,4,4-trifluoro-1-(2-naphthyl)-1,3-butanedionato]europium (3+) diphenyl-phosphonimidotriphenyl phosphorane (F.W. 1424) (ALP-7)

Prepare Dean and Starke distillation headed flask and into it place:
10 millimoles europium III (NTFA)₃2H₂O (as above), 9.83 grams
10 millimoles diphenyl-phosphonimido-triphenyl phosphorane - prepared as described in Example 1, 4,77 grams Benzene (Aldrich 15630-2) 50 ml.

Reflux these components together using the Dean and Starke head to remove water from the system as the components dissolve and form the anhydrous ALP-7-approximately 300 microlitres water collected. Reflux a further 30 minutes, then allow the reaction solution to cool. Evaporate off the solvent at room temperature to yield a dry solid. Remove the last traces of solvent under a hard vacuum at 4°C.

**Note**: The reaction has to be carried out using benzene not toluene as disproportionation occurs when toluene is used - resulting in a red tar being produced.

The material is used as produced as it has not been possible to crystallise the material - an oil is produced from all solvents.

### 3. Preparation of the bis-phosphorane of europium(III) (NTFA)₃

Prepared as above but using 20 millimoles diphenyl phosphonimido triphenyl phosphorane instead of 10 millimoles.

### B. PREPARATION OF TRITIUM CARRIER

### - See Example 3.

### C. FORMULATION OF INACTIVE MONOMER SOLUTIONS

- As per Example 3 for preparation of inactive components except that the phosphors used were:
   (a) Europium(III) (NTFA)₃ - after removal of water by azeotroping in benzene.
   (b) Europium(III) (NTFA)₃phosphorane (ALP-7) as prepared above.
   (c) Europium(III) (NTFA)₃bis-phosphorane.

Formulations were prepared generally as per Example 3 but varying the Dow 704 and styrene proportions as follows:
Dow 704/Styrene 50/50, 75/25 and 100/0

The initial light output results (in Ev) from LEP made as described above are tabulated below:

| | PHOSPHOR USED AT 7.5% CONCENTRATION | | |
|---|---|---|---|
| Dow 704/ Styrene Ratio | Eu(NTFA)₃ | Eu(NTFA)₃ phos (ALP-7) | Eu(NTFA)₃ bis-phos. |
| 50/50 | 0.10 | 3.01 | 2.25 |
| 75/25 | 0.05 | 2.01 | 1.72 |
| 100/0 | 0.24 | 4.64 | 3.32 |

### CONCLUSIONS Light Output

1. The mono-phosphorane derivative, (ALP-7), generates much more light than the un-phosphoraned material or the bis-phosphoraned material.
2. The 100% siloxane (Dow 704) versions of LEP give much more light than the 50/50 or the 75/25 versions with all three phosphors.
3. The stability of the ALP-7 formulation was good; that of the other two formulations appeared very poor.

This experiment demonstrates that total replacement of styrene by siloxane in LEP formulations can yield significantly increased light output and probably this will also yield more stable formulations.

### EXAMPLE 5

### 1. Preparation of Polymer

ALP-1 was prepared as per Example 1. Other components of this polymer, excluding any tritium carrier, were prepared as per Example 3.

Formulation and polymerisation of the inactive monomer solution was generally as per Example 3 excluding any tritium carrier but including, for this experiment, 1% by weight of fumed silica to minimize light piping.

### 2. Experiment to determine whether the polymer can be used as a solid scintillant

### A. Experiment

i) Ten scintillation vials were taken.
ii) To each (1-10) was added 5 ml ethanol.
iii) To vials 1, 3, 5, 7 + 9 was added a microtomed slice of polymer 15 microns thick of area approximately 3 square centimetres.
iv) All ten vials were put into a scintillation counter (RackBeta set to detect tritium beta scintillations including those at wavelengths produced by ALP-1) and counted to determine any "background".
v) Twelve microcuries tritiated siloxane, prepared as per Example 3, contained in one microlitre ethanol was added to all ten vials and each vial was counted three times.

### B. Results

The average of three counts minus background for the vials containing just ethanol and the 12 microcuries was 120 CPM. The average of three counts minus background for the vials containing slices of polymer was 1392 CPM, i.e. the presence of polymer raised the CPM by over 10 times (11.6).

### C. Conclusion

The polymer can be used as a solid scintillant.

## Claims

1. A fluorescent body composed of a polymer together with a chelate of a transition or lanthanide or actinide metal ion, said chelate present in the form of a complex with a reagent selected from the group consisting of phosphine oxides of formula 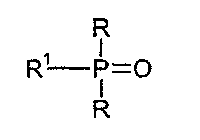 and imido-reactants of formula 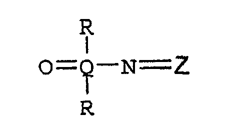
where R is aromatic or heterocyclic,
R¹ is R or 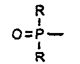
Q is Phosphorus or Arsenic, and
Z is QR₃ or oligophosphoranyl,
which body is transparent or translucent and has the property of emitting light or infra-red radiation when subjected to ultra-violet or ionising radiation,
**characterised in that** there is present a free-radical scavenger which reduces polymer degradation.

2. A radioluminescent body composed of a polymer together with a chelate of a transition or lanthanide or actinide metal ion, which body is transparent or translucent, wherein the body is radioactively labelled with tritium and has the property of emitting light or infra-red radiation by virtue of internally generated ionizing radiation resulting from radioactive decay of the tritium, **characterised in that** there is present a free-radical scavenger which reduces polymer degradation.

3. A body as claimed in claim 2, wherein the said chelate is present in the form of a complex with a reagent selected from the group consisting of phosphine oxides of formula 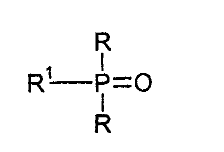 and imido-reactants of formula 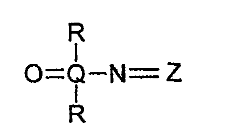
where R is aromatic or heterocyclic,
R¹ is R or 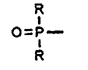
Q is Phosphorus or Arsenic, and
Z is QR₃ or oligophosphoranyl.

4. A body as claimed in claim 1 or claim 3, wherein the reagent is a phosphine oxide R₃PO where the three groups R are phenyl, phenyl and p-tolyl.

5. A body as claimed in claim 1 or claim 3 composed of an organic polymer together with a compound that results from reacting p-tolyldiphenylphosphine oxide with trivalent terbium tris (dipivaloyl methide); or with a compound that results from reacting diphenyl-phosphonimido-triphenyl phosphorane with tris [4,4,4-trifluoro-1-(2-naphthyl)-1,3-butanedionato] europium (3+).

6. A body as claimed in any one of claims 1 to 5, wherein there is present a siloxane which improves the stability and light output.

7. A body as claimed in claim 6, wherein the siloxane is present in a proportion of 10- 40% by weight on the weight of the body.

8. A body as claimed in claims 6 or claim 7, wherein the siloxane comprises 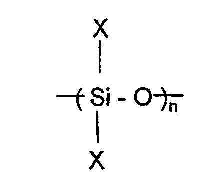 where X is aromatic or heterocyclic or C1-C4 alkyl or alkenyl and n is an integer of at least 1.

9. A body as claimed in any one of claims 1 to 8, wherein the free radical scavenger is tetralin.

10. A body as claimed in any one of claims 1 to 9, wherein a siloxane radioactively labelled with tritium is present.

11. A body as claimed in any one of claims 1 to 10, wherein the polymer is selected from the group consisting of poly(vinylaromatics) and polysiloxanes and mixtures of these.

## Patentansprüche

1. Fluoreszierender Körper, zusammengesetzt aus einem Polymer, zusammen mit einem Chelat eines Übergangs- oder Lanthanid- oder Actinidmetallions, wobei das Chelat in Form eines Komplexes mit einem Reagenz vorliegt, ausgewählt aus der Gruppe, bestehend aus Phosphinoxiden der Formel 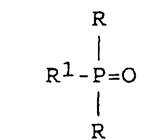 und Imidoreaktanten der Formel 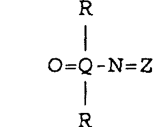
worin R aromatisch oder heterocyclisch ist,
R¹ R oder 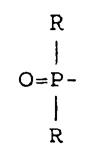 ist,
Q Phosphor oder Arsen ist und
Z QR₃ oder Oligophosphoranyl ist,
wobei der Körper durchsichtig oder durchscheinend ist und die Eigenschaft, Licht oder Infrarotstrahlung zu emittieren, wenn er Ultraviolett- oder ionisierender Strahlung ausgesetzt ist, aufweist,
**dadurch gekennzeichnet, dass** ein Fänger für freie Radikale vorliegt, der den Polymerabbau vermindert.

2. Radiolumineszierender Körper, zusammengesetzt aus einem Polymer, zusammen mit einem Chelat von einem Übergangsoder Lanthanid- oder Actinidmetallion, wobei der Körper durchsichtig oder durchscheinend ist, wobei der Körper mit Tritium radioaktiv markiert ist und die Eigenschaft, Licht oder Infrarotstrahlung durch eine im Inneren erzeugte, beim radioaktiven Zcrfall von Tritium entstehende ionisierende Strahlung zu emittieren, aufweist, **dadurch gekennzeichnet, dass** ein Fänger für freie Radikale vorliegt, der den Polymerabbau vermindert.

3. Körper nach Anspruch 2, wobei das Chelat in Form eines Komplexes mit einem Reagenz vorliegt, ausgewählt aus der Gruppe, bestehend aus Phosphinoxiden der Formel 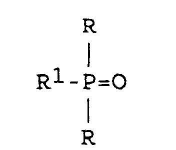 und Imidoreaktanten der Formel 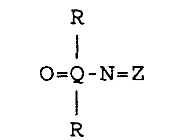
worin R aromatisch oder heterocyclisch ist,
R¹ R oder 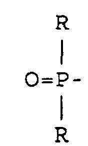 ist,
Q Phosphor oder Arsen ist und
Z QR₃ oder Oligophosphoranyl ist.

4. Körper nach Anspruch 1 oder Anspruch 3, wobei das Reagenz ein Phosphinoxid R₃PO darstellt, worin die drei Gruppen R Phenyl, Phenyl und p-Tolyl sind.

5. Körper nach Anspruch 1 oder Anspruch 3, zusammengesetzt aus einem organischen Polymer, zusammen mit einer Verbindung, die bei der Umsetzung von p-Tolyldiphenylphosphinoxid mit dreiwertigem Terbiumtris(dipivaloylmethid) entsteht oder mit einer Verbindung, die bei der Umsetzung von Diphenylphosphonimidotriphenylphosphoran mit Tris[4,4,4-trifluor-1-(2-naphthyl)-1,3-butandionato]europium(3+) entsteht.

6. Körper nach einem der Ansprüche 1 bis 5, wobei ein Siloxan vorliegt, das die Stabilität und den Lichtausstoß verbessert.

7. Körper nach Anspruch 6, wobei das Siloxan in einem Anteil von 10-40 Gewichtsprozent auf das Gewicht des Körpers vorliegt.

8. Körper nach Ansprüchen 6 oder 7, wobei das Siloxan 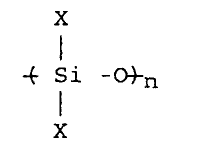 umfasst,
worin X aromatisch oder heterocyclisch oder C₁-C₄-Alkyl oder Alkenyl darstellt und n eine ganze Zahl von mindestens 1 ist.

9. Körper nach einem der Ansprüche 1 bis 8, wobei der Fänger für freie Radikale Tetralin ist.

10. Körper nach einem der Ansprüche 1 bis 9, wobei ein mit Tritium radioaktiv markiertes Siloxan vorliegt.

11. Körper nach einem der Ansprüche 1 bis 10, wobei das Polymer ausgewählt ist aus der Gruppe, bestehend aus Poly(vinylaromaten) und Polysiloxanen und Gemischen von diesen.

## Revendications

1. Corps fluorescent composé d'un polymère et en même temps d'un chélate d'un ion de métal de transition ou de lanthanide ou d'actinide, ledit chélate est présent sous la forme d'un complexe avec un réactif choisi parmi les oxydes de phosphine de formule 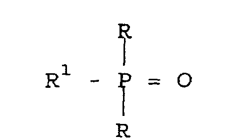 et les réactifs de type imide de formule 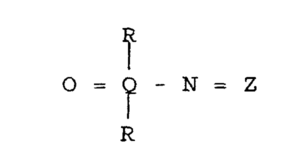 dans laquelle R est aromatique ou hétérocyclique,
R¹ est R où 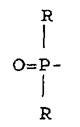
Q est un atome de phosphore ou d'arsenic, et
Z est QR₃ ou un groupe oligophosphoranyle,
lequel corps est transparent ou translucide et a la propriété d'émettre de la lumière ou du rayonnement infrarouge lorsqu'il est soumis à un rayonnement UV ou à des radiations ionisantes,
**caractérisé en ce qu'**un absorbant de radicaux libres qui réduit la dégradation du polymère est présent..

2. Corps radioluminescent composé d'un polymère et en même temps d'un chélate d'un ion de métal de transition ou de lanthanide ou d'actinide, lequel corps est transparent ou translucide, dans lequel le corps est marqué de manière radioactive avec du tritium et a la propriété d'émettre de la lumière ou du rayonnement infrarouge en vertu de la radiation ionisante générée intérieurement qui résulte de la décroissance radioactive du tritium, **caractérisé en ce qu'**un absorbant de radicaux libres qui réduit la dégradation du polymère est présent.

3. Corps selon la revendication 2, dans lequel ledit chélate est présent sous la forme d'un complexe avec un réactif choisi parmi les oxydes de phosphine de formule 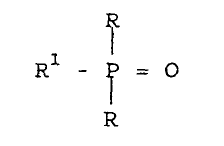 et les réactifs de type imide de formule 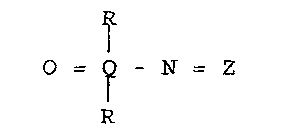 dans laquelle R est aromatique ou hétérocyclique,
R¹ est R ou 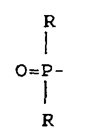
Q est un atome de phosphore ou d'arsenic, et
Z est QR₃ ou un groupe oligophosphoranyle.

4. Corps selon la revendication 1 ou la revendication 3, dans lequel le réactif est un oxyde de phosphine R₃PO dans lequel les trois groupes R sont les groupes phényle, phényle et p-tolyle.

5. Corps selon la revendication 1 ou la revendication 3 composé d'un polymère organique avec un composé qui résulte de la réaction de l'oxyde de p-tolyldiphénylphosphine avec le terbium trivalent tris (dipivaloylméthide); ou avec un composé qui résulte de la réaction du diphényl-phosphonimido-triphényl-phosphorane avec le tris[4,4,4-trifluoro-1-(2-naphtyl)-1,3-butanedionato]europium (3+).

6. Corps tel que revendiqué dans l'une quelconque des revendications 1 à 5, dans lequel un siloxane qui améliore la stabilité et l'émission de sortie de lumière est présent.

7. Corps tel que revendiqué dans la revendication 6, dans lequel le siloxane est présent en une proportion de 10 - 40% en poids du poids du corps.

8. Corps tel que revendiqué dans la revendication 6 ou la revendication 7, dans lequel le siloxane comprend 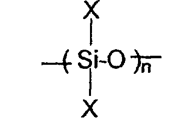 dans lequel X est un groupe aromatique ou hétérocyclique ou alkyle ou alcényle en C₁-C₄ et n est un entier d'au moins 1.

9. Corps tel que revendiqué dans l'une quelconque des revendications 1 à 8, dans lequel l'absorbant de radicaux libres est la tétraline.

10. Corps tel que revendiqué dans l'une quelconque des revendications 1 à 9, dans lequel est présent un siloxane marqué radioactivement au tritium.

11. Corps tel que revendiqué dans l'une quelconque des revendications 1 à 10, dans lequel le polymère est choisi parmi les composés polyvinyliques aromatiques et les polysiloxanes et les mélanges de ceux-ci.
